(19) Europäisches Patentamt
European Patent Office
Office européen des brevets

(11) Publication number: **0 162 676**
**A2**

# (12) EUROPEAN PATENT APPLICATION

(21) Application number: 85303487.4

(22) Date of filing: 17.05.85

(51) Int. Cl.[4]: H 05 K 13/02
H 05 K 13/00

(30) Priority: 17.05.84 US 611418

(43) Date of publication of application:
27.11.85 Bulletin 85/48

(84) Designated Contracting States:
AT BE CH DE FR GB IT LI LU NL SE

(71) Applicant: PROCONICS INTERNATIONAL INC.
163 F New Boston Street
Woburn, MA 01801(US)

(72) Inventor: Foulke, Richard F.
43 Indian Hill Road
Carlisle Massachusetts(US)

(74) Representative: Deans, Michael John Percy et al,
Lloyd Wise, Tregear & CO. Norman House 105-109
Strand
London WC2R OAE(GB)

## (54) Rolling apparatus.

(57) Rolling apparatus, for example for moving semiconductor wafers in a clean environment, has a support member with a bearing connected thereto. The bearing is mounted for rotation about its axis relative to the support member. A tyre formed of a material which is softer than the bearing is mounted on its circumference. The tyre has a circumference that increases across its width from a smaller diameter side to a larger diameter side. A lip extends radially inwardly over a portion of the bearing on the larger diameter side of the tyre. The lip is biased against the bearing as the tyre travels, and the tyre is prevented from moving off the bearing at either side.

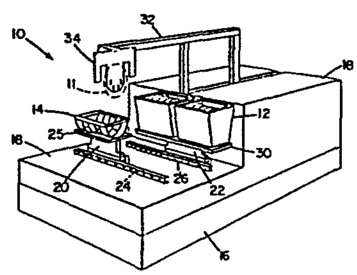


FIG I

EP 0 162 676 A2

# ROLLING APPARATUS

## Description

This invention relates to rolling apparatus useful, e.g., in apparatus for placing semiconductor wafers in holders or boats.

Apparatus for transferring semiconductor wafers from plastics storage boats to quartz processing boats, and vice versa, is described in our International Patent Application PCT/US83/00783 (Publication No. WO83/04240), the entire disclosure of which is hereby incorporated by reference. In this apparatus, the plastics and quartz boats are supported on trolleys that move the wafers past a pickup arm via metal rollers rolling along tracks located within the apparatus. In moving the wafers between the boats, it is desirable to avoid introduction of contamination on to the surfaces of the wafers. Such contamination can arise from scraping and sliding of parts within the apparatus being used to accomplish the transfer.

In accordance with the present invention, we provide rolling apparatus comprising: a support member; bearing means connected to said support member and mounted for rotation about its axis relative to said support member; and a tyre formed of a material which is softer than said bearing means and mounted on the circumference of said bearing means; characterised in that said tyre has a circumference that increases across its width from a smaller diameter side to a larger diameter side and a lip extending radially inward over a portion of said bearing means on the larger diameter side of said tyre, whereby said lip is biased against said bearing means as said tyre travels, and said tyre is prevented from moving off said bearing means at either side.

In preferred embodiments the tyre is made of plastics (most preferably polyformaldehyde); the tyre rolls along a track; the track has two surfaces inclined to the horizontal, and there are two tyres, each engaging a different inclined surface; the track has two upper inclined surfaces and two lower inclined surfaces, and there is a tyre engaging each inclined surface; and the circumferences of the tyres increase away from the support member.

In the preferred application of the roller apparatus in apparatus operating in a contaminant free environment (most preferably apparatus transferring semiconductor wafers), the use of soft material acts to avoid particulate contamination resulting from interaction of moving hard parts.

Other features and advantages of the invention will be apparent from the following description of the preferred embodiment, and from the claims.

We first briefly describe the drawings wherein

Fig. 1 is a perspective view of apparatus for moving semiconductor wafers from one carrier to another;

Fig. 2 is a vertical sectional view of a roller and track mechanism of the apparatus of Fig. 1;

Fig. 3 is an elevation, partially in section, of a roller element of the Fig. 2 mechanism; and

Fig. 4 is an enlarged vertical sectional view of the tyre of Fig. 3 roller element.

Referring to Fig. 1, there is shown wafer handling apparatus 10, for transferring semiconductor wafers 11 between plastics boats 12 and quartz boat 14.

Apparatus 10 has base 16 upon which cover 18 rests, trolleys 20, 22 for transporting the boats, and wafer transfer arm 32. Trolleys 20, 22 extend through slots 24, 26, respectively, of cover 18. Trolley 20 has affixed to its upper end platform 25, which supports quartz boat 14. Trolley 22 has affixed to its upper end platform 30, which supports plastics boats 12. Arm 32 is connected to aluminium wafer paddle 34 for gripping wafers by vacuum engagement.

Referring to Fig. 2, the roller and track mechanism for trolley 22 is shown. (A similar roller and track mechanism is used for trolley 20.) Aluminium track 46 has inclined surfaces 50 inclined at 45° to the horizontal and running longitudinally along its top and bottom. Trolley 22 is supported on track 46 by roller bars 44, each of which has a pair of rollers 28 resting on surfaces 50. Each roller 28 rotates on a stationary shaft which is pressed into a roller bar and held by a set screw. A spacer on the shaft prevents contact between roller 28 and roller bar 44, while a snap ring holds the roller on the shaft.

Referring to Fig. 3, roller 28 has a plastics tyre 40 (# 150 Delrin polyformaldehyde from DuPont) mounted on bearing 42 (R4 bearing, ABEC 5 tolerance, 5/8" (1.5875cm) o.d., 1/4" (0.635cm) bore, 0.195" (0.4953cm) wide).

Referring to Fig. 4, the circumference of tyre 40 increases away from roller bar 44 (from left to right in Figs. 3 and 4) at an angle of 1.5° ± .5° from 0.674/0.673" (1.608cm) at edge 62 to 0.687" (1.643cm) at edge 58. Lip 52 is 0.025" (0.0635cm) wide. Lip opening 54 is 0.562" (1.427cm) in diameter. Inner surface 56 is 0.624/0.623" (1.585/1.582cm) in diameter. Opening 60 at the left side of the tyre is 0.611± .001" (1.552± .003cm) in diameter. Inside corners 64 are at an angle of 40° to inner surface 60. The width of tyre 40 is 0.240" (0.610cm) from edge 58 to edge 62, and 0.189/0.192" (0.479/0.488cm) along inner surface 56.

To ensure the necessary outer dimensions of tyre 40, the plastics is not machined to final dimensions until tyre 40 has been mounted on bearing 42.

The overall operation of apparatus 10 in transferring wafers 11 between plastics boats 12 and quartz boat 14 is described in the above-mentioned patent application. During the transfer process, trolleys 20, 22 move along their respective tracks to align different wafers and slots of boats 12, 14 with paddle 34. Cover 18 inhibits contaminants from surfacing.

Precise contaminant free movement of trolleys 20, 22 is provided by using soft plastics tyres 40, which resist chipping and abrading, thus eliminating particulate contaminants associated with the abrasion of metal or with hard surface rollers on a metal track. Also, use of plastics tyres 40 permits the use of aluminium for track 46, something which can be more easily machined than harder metals that are used to avoid contamination with metal rollers.

As a tyre 40 engages track 16 at an inclined surface 50, the increasing circumference of the tyre away from roller bar 44 biases the tyre toward the roller bar, preventing the soft tyre from moving outward, and the tyre is prevented from moving off the bearing and into the roller bar by means of tyre lip 52.

Other embodiments are envisaged within the scope of the invention. For example, the tyre may be made of other plastics, and the small lip at opening 60 is not needed to hold tyre 40 in place. The bearing may be of a different manufacture. The roller may be used in conjunction with other machines, particularly those needing a contaminant-free environment.

CLAIMS

1. Rolling apparatus comprising:

a support member;

bearing means connected to said support member and mounted for rotation about its axis relative to said support member; and a tyre formed of a material which is softer than said bearing means and mounted on the circumference of said bearing means; characterised in that said tyre has a circumference that increases across its width from a smaller diameter side to a larger diameter side and a lip extending radially inward over a portion of said bearing means on the larger diameter side of said tyre,

whereby said lip is biased against said bearing means as said tyre travels, and said tyre is prevented from moving off said bearing means at either side.

2. Apparatus according to Claim 1, further characterised in that said tyre is made of plastics material.

3. Apparatus according to Claim 2, further characterised in that said plastics material comprises polyformaldehyde.

4. Apparatus according to any preceding claim, further comprising a track, said tyre being in rolling engagement with said track; and being further characterised in that said track has two surfaces oppositely inclined to the horizontal, and in that a second said bearing means with a second said tyre mounted thereon is mounted for rotation about its axis relative to said support member, each said tyre engaging a respective said surface.

5. Apparatus according to Claim 4, further characterised in that said two surfaces are two upper inclined surfaces, in that said track further comprises two lower surfaces oppositely inclined to the horizontal, and in that third and fourth said bearing means respectively mounting third and fourth said tyres are mounted for rotation about their respective axes relative to said support member, with said third and fourth tyres respectively engaging said lower inclined surfaces.

6. Transport apparatus adapted for moving objects on a carrier in a clean environment, characterised in that it comprises: rolling apparatus according to any of Claims 1, 2 or 3 provided with at least one other said bearing means mounted for rotation about its axis relative to said support and having a said tyre mounted thereon, said support member being adapted for support and carriage of said carrier; and a co-operating track along which said rolling apparatus is adapted to run.

7. Transport apparatus adapted for moving objects on a carrier in a clean environment, characterised in that it comprises rolling apparatus according to Claims 4 or 5, said support member being adapted for support and carriage of said carrier as said support member travels along said track.

8. Apparatus according to Claim 6 or Claim 7, further characterised in that it is adapted for moving semiconductor wafers and further includes means for placing semiconductor wafers in said carrier.

9. Apparatus according to any of Claims 6, 7 or 8, further characterised in that at least said track and said bearings are contained within a housing.

10. Apparatus according to any of Claims 4 to 9, further characterised in that the circumference of each said tyre increases across its width in the direction away from said support member.

0162676

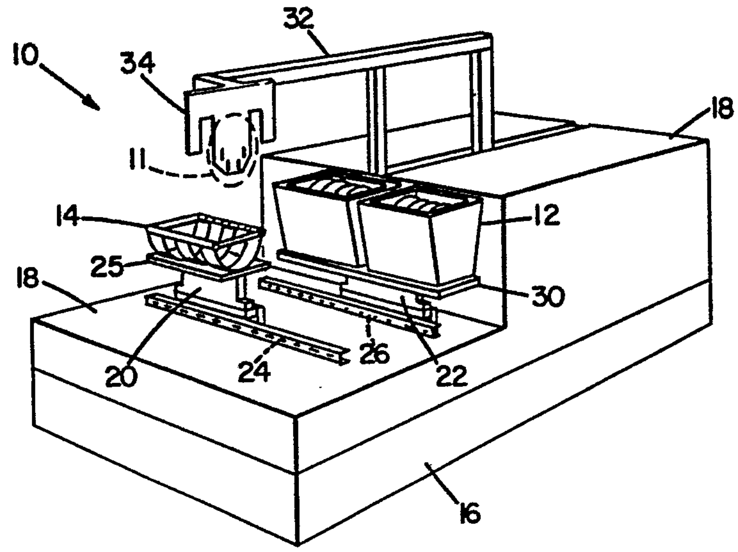


FIG 1

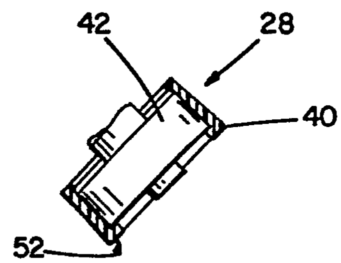


FIG 3

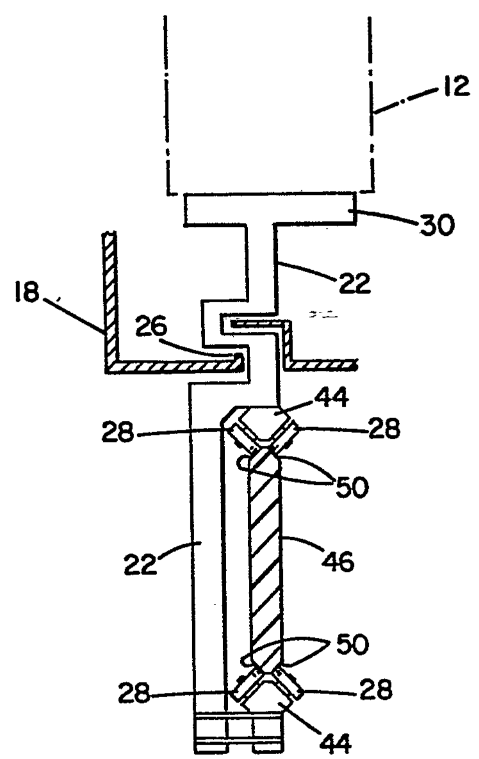


FIG 2

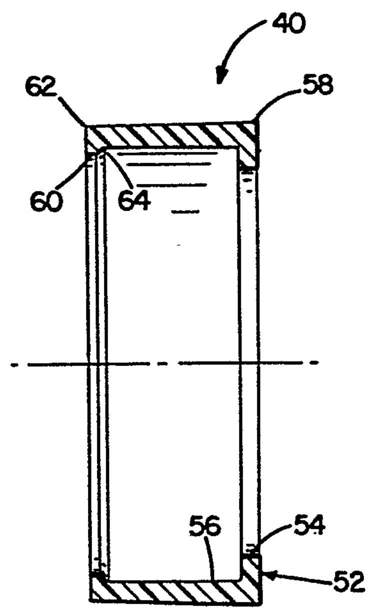


FIG 4